(19) Europäisches Patentamt
European Patent Office
Office européen des brevets

(11) **EP 3 182 447 B1**

(12) **FASCICULE DE BREVET EUROPEEN**

(45) Date de publication et mention
de la délivrance du brevet:
**25.07.2018 Bulletin 2018/30**

(51) Int Cl.:
***H01L 23/373*** [(2006.01)]     ***H01L 23/427*** [(2006.01)]

(21) Numéro de dépôt: **16204780.7**

(22) Date de dépôt: **16.12.2016**

(54) **DISPOSITIF COMPOSITE D'ABSORPTION THERMIQUE ET METHODE D'OBTENTION**

VERBUNDWERKSTOFFBAUTEIL ZUR WÄRMEABSORPTION, UND HERSTELLUNGSMETHODE

COMPOSITE HEAT-ABSORPTION DEVICE AND METHOD FOR OBTAINING SAME

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **17.12.2015 FR 1562602**

(43) Date de publication de la demande:
**21.06.2017 Bulletin 2017/25**

(73) Titulaire: **COMMISSARIAT À L'ÉNERGIE ATOMIQUE ET AUX ÉNERGIES ALTERNATIVES**
**75015 Paris (FR)**

(72) Inventeurs:
• **SOUPREMANIEN, Ulrich**
**38160 Saint Marcellin (FR)**
• **OLLIER, Emmanuel**
**38000 GRENOBLE (FR)**

(74) Mandataire: **Brevalex**
**95, rue d'Amsterdam**
**75378 Paris Cedex 8 (FR)**

(56) Documents cités:
**WO-A1-2013/104620    US-A1- 2012 273 920**

• **MI ZHOU ET AL: "Highly Conductive Porous Graphene/Ceramic Composites for Heat Transfer and Thermal Energy Storage", ADVANCED FUNCTIONAL MATERIALS, WILEY - V C H VERLAG GMBH & CO. KGAA, DE, vol. 23, no. 18, 13 mai 2013 (2013-05-13), pages 2263-2269, XP001582791, ISSN: 1616-301X, DOI: 10.1002/ADFM.201202638**

## Description

### DOMAINE TECHNIQUE ET ART ANTÉRIEUR

La présente invention se rapporte à la mise en oeuvre d'un dispositif d'absorption thermique amélioré pouvant être utilisé par exemple pour le refroidissement de composants électroniques.

Dans les dispositifs électroniques, sont confinés un nombre de plus en plus important de fonctionnalités. On cherche simultanément à réduire la taille de ces composants. Cette tendance conduit à la nécessité de devoir dissiper une quantité de chaleur croissante par unité de volume (ou de masse) de composant.

Le problème de la dissipation de chaleur prend une ampleur particulièrement importante dans les dispositifs 3D dont les composants électroniques (par exemple des cellules mémoires) sont répartis sur plusieurs niveaux et dimensions ou bien dans les dispositifs électroniques de puissance.

Outre la quantité plus importante de chaleur à évacuer se pose le problème de l'évacuation de chaleur en mode transitoire, lorsque le flux de chaleur est relativement élevé et la durée de la charge est relativement courte.

La mise en oeuvre de dispositifs d'absorption thermique dotés d'un matériau à changement de phase (MCP) est connue. Ces matériaux permettent de stocker des quantités de chaleur significatives du fait de leur transition de phase, typiquement d'un état solide vers un état liquide.

Le document "A carbon nanotube-based composite for the thermal control of heat loads", de Shaikh et al., Carbon, Elsevier, Volume 50, Issue 2, 2012, pages 542-550 présente un dispositif de gestion thermique disposé entre une source chaude et une source froide et formé d'un empilement de compartiments, chaque compartiment étant doté d'une paroi enfermant un matériau à changement de phase. WO 2013/104620 divulgue un dispositif d'absorption thermique comportant une première face destinée à être en contact avec une source chaude et une deuxième face opposée à la première face, un réseau de cellules remplies d'un premier matériau à changement de phase étant disposé entre la première face et la deuxième face , au moins une première cellule et au moins une deuxième cellule du réseau étant disposées dans un même plan parallèle à la première face, la première cellule comportant une première paroi latérale qui s'étend entre la première face et la deuxième face tandis que la deuxième cellule comporte au moins une première paroi latérale qui s'étend entre la première face et la deuxième face, le réseau de cellules étant agencé de sorte qu'un passage est prévu entre la première paroi latérale et la deuxième paroi latérale. Un tel type de dispositif n'est adapté qu'à la gestion thermique d'une source chaude uniforme.

### EXPOSÉ DE L'INVENTION

C'est un but de la présente invention d'offrir un dispositif d'absorption thermique efficace pour évacuer la chaleur d'une source chaude non uniforme et en particulier formée d'éléments susceptibles de subir des échauffements différents, cette source chaude étant par exemple un dispositif électronique avec des composants juxtaposés ayant des gammes de températures de fonctionnement différentes ou des températures critiques de fonctionnement différentes. Par gammes de températures de fonctionnement différentes on entend que lorsque ces composants sont en fonctionnement leurs puissance dissipées respectives ne sont pas les mêmes.

Selon un aspect, la présente invention concerne un dispositif d'absorption thermique comportant des cellules contenant un premier matériau à changement de phase solide/liquide, ainsi qu'un passage entre cellules contenant un deuxième matériau à changement de phase solide/liquide, le premier matériau et le deuxième matériau à changement de phase étant répartis dans un même plan parallèle à une face du dispositif d'absorption thermique destinée à être mise en contact thermique avec la source chaude, par exemple sous forme d'une pluralité de composants juxtaposés.

Un mode de réalisation de la présente invention prévoit un dispositif d'absorption thermique comportant une première face destinée à être en contact avec une source chaude et une deuxième face opposée à la première face, un réseau de cellules remplies d'un premier matériau à changement de phase étant disposé entre la première face et la deuxième face, au moins une première cellule et au moins une deuxième cellule du réseau étant disposées dans un même plan parallèle à la première face, la première cellule comportant une première paroi latérale qui s'étend entre la première face et la deuxième face tandis que la deuxième cellule comporte au moins une première paroi latérale qui s'étend entre la première face et la deuxième face,

le réseau de cellules étant agencé de sorte qu'un passage est prévu entre la première paroi latérale et la deuxième paroi latérale et que ce passage est rempli d'au moins un deuxième matériau à changement de phase différent du premier matériau à changement de phase.

Les cellules remplies du premier matériau à changement de phase (MCP) peuvent être prévues pour réaliser un écrêtage thermique d'un premier élément de la source chaude, tandis que le passage situé entre des cellules et rempli du deuxième matériau à changement de phase (MCP) peut être dédié à la réalisation d'un écrêtage thermique d'un deuxième élément de la source chaude ayant une plage de fonctionnement en température différente de celle du premier élément.

On met ainsi en oeuvre une structure composite à 2 (ou plus) matériaux à changement de phase capable d'absorber de la chaleur par enthalpie de changement de phase à au moins deux températures différentes.

Avantageusement, la première paroi latérale et la deuxième paroi latérale sont formées en nanotubes de carbone.

Grâce à leur bonne conductivité thermique, les nanotubes assurent une évacuation de la chaleur en régime nominal par conduction. Les nanotubes sont de préférence en contact les uns avec les autres de sorte que les parois des cellules soient en matériau dense.

Avantageusement au moins la première cellule comporte plusieurs canaux distincts qui s'étendent entre la première face et la deuxième face et sont remplis du deuxième matériau à changement de phase.

Une structure avec plusieurs canaux par cellule présente notamment une tenue mécanique améliorée.

De préférence, le premier matériau à changement de phase située dans les cellules a une première température de fusion TF1 tandis que le deuxième matériau à changement de phase a une deuxième température de fusion TF2, la deuxième température de fusion TF2 étant inférieure à la première température de fusion TF1.

Le premier matériau à changement de phase peut être un matériau organique. Le premier matériau est choisi de préférence de sorte à présenter, sous sa forme liquide une faible viscosité et une affinité importante avec le matériau formant les cellules. Par « faible » viscosité on entend une viscosité typiquement inférieure à 1000 centipoise (cP). Par « affinité importante » on entend en particulier que le matériau sous sa forme liquide présente une bonne mouillabilité c'est à dire telle qu'un angle de contact typiquement inférieur à 60° et en particulier à 45° est établi avec le matériau formant les cellules.

Ainsi, le premier matériau à changement de phase peut être avantageusement une paraffine en particulier lorsque les cellules sont en nanotubes de carbone.

Le deuxième matériau à changement de phase peut être un matériau organique ou inorganique, de préférence ayant une bonne conductivité thermique tel qu'un matériau métallique.

Une structure dotée de plusieurs canaux par cellule peut permettre d'intégrer un matériau à changement de phase organique et éventuellement peu conducteur thermique, la conduction thermique étant alors réalisée principalement par les parois des canaux, en particulier lorsque ceux-ci sont en nanotubes de carbone.

Selon un autre aspect, la présente invention concerne un système électronique comportant :

- au moins un premier composant électronique formant une première source de chaleur,
- au moins un deuxième composant électronique formant une deuxième source de chaleur,
- au moins un dispositif d'absorption thermique tel que défini précédemment, le premier composant électronique et le deuxième composant électronique étant en contact thermique avec la première face du dispositif d'absorption thermique.

Selon un autre aspect, la présente invention concerne un procédé de fabrication d'un dispositif de gestion thermique tel que défini précédemment.

Ce procédé peut comporter des étapes de :

a) remplissage d'au moins une première cellule et d'au moins une deuxième cellule du réseau avec le premier matériau à changement de phase dans son état liquide, puis

b) remplissage avec le deuxième matériau à changement de phase dans son état liquide d'un passage situé entre la première cellule et la deuxième cellule.

Les cellules peuvent comporter des canaux distincts de dimension critique inférieure à la dimension critique du passage entre la première cellule et une deuxième cellule.

On facilite dans ce cas le remplissage sélectif des canaux par le premier matériau à changement de phase à l'étape a).

Par « dimension critique » d'un motif, on entend ici et dans toute la présente description la plus petite dimension d'un motif hormis son épaisseur ou sa hauteur.

Lorsque le premier matériau à changement de phase a une première température de fusion supérieure à la température de fusion du deuxième matériau à changement de phase, on effectue avantageusement le remplissage à l'étape b) à une température inférieure à la température de fusion du premier matériau à changement de phase.

Dans ce cas on évite de détériorer le premier matériau à changement de phase.

Préalablement à l'étape a), le procédé de fabrication peut comprendre des étapes de :

- définition d'un motif du réseau de cellules dans un masquage formé (en particulier par photolithographie) sur un support, puis
- dépôt d'une couche de catalyseur, puis
- retrait du masquage, puis
- croissance de nanotubes de carbone de sorte à définir le réseau de cellules avec des parois latérales en nanotubes de carbone.

**BRÈVE DESCRIPTION DES DESSINS**

La présente invention sera mieux comprise à la lecture de la description d'exemples de réalisation donnés, à titre purement indicatif et nullement limitatif, en faisant référence aux dessins annexés sur lesquels :

- les figures 1A et 1B sont des vues en coupe longitudinale et transversale respectivement d'une représentation schématique d'un exemple de réalisation d'un dispositif d'absorption thermique selon l'invention ;
- les figures 2A à 2H sont des représentations schématiques d'étapes de réalisation du dispositif d'absorption thermique lorsque celui-ci est formé d'un réseau de cellules en nanotubes de carbone ;

- la figure 3 est une courbe temps-température servant à illustrer les performances d'un dispositif doté de plusieurs matériaux à changement de phase ;
- la figure 4 est une vue en coupe d'un exemple de système doté d'un dispositif d'absorption thermique à plusieurs matériaux à changement de phase selon l'invention sur une face duquel plusieurs composants électroniques ayant des plages de fonctionnement différentes et des températures critiques de fonctionnement différentes sont agencés ;
- la figure 5 sert à illustrer les performances d'un tel système en comparaison avec un dispositif intégrant un seul matériau à changement de phase.

En outre, dans la description ci-après, des termes qui dépendent de l'orientation du dispositif, telle que « latérale », « supérieure », « inférieure », s'appliquent en considérant que la structure est orientée de la façon illustrée sur les figures.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

## EXPOSÉ DÉTAILLÉ DE MODES DE RÉALISATION PARTICULIERS

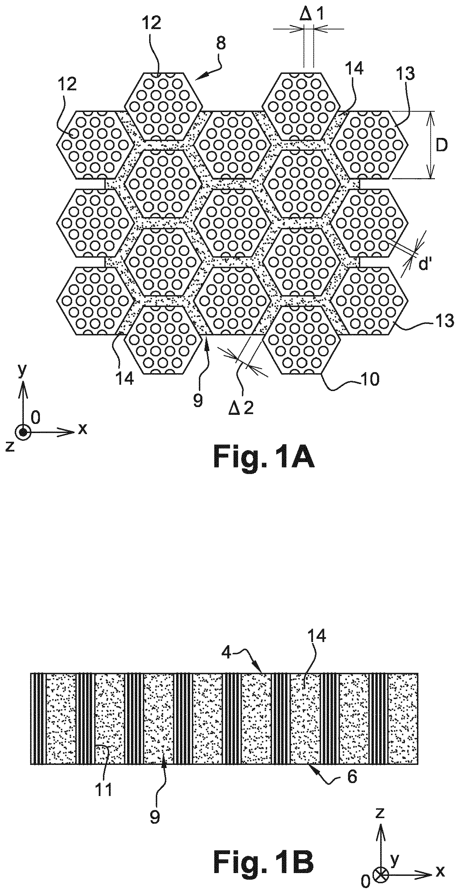

Un exemple de réalisation d'un dispositif d'absorption thermique suivant l'invention va à présent être décrit en liaison avec les figures 1A et 1B (donnant respectivement une vue de dessus et une vue en coupe transversale du dispositif).

Ce dispositif est destiné à être disposé sur un élément (non représenté) appelé « source chaude » dont on souhaite gérer l'échauffement. Par exemple, la source chaude est un dispositif électronique doté d'au moins un composant électronique, tel qu'une mémoire, un processeur, un circuit intégré planaire ou 3D, un composant d'électronique de puissance. A titre d'exemple de composant de puissance on peut citer notamment les thyristors de type GTO (de l'anglais "Gâte Turn-Off Thyristor") ou les transistors bipolaire(s) à grille isolée (IGBT, de l'anglais « Insulated Gâte Bipolar Transistor ») ou les thyristors IGCT (pour « Integrated Gate-Commutated Thyristor »).

Le dispositif d'absorption thermique a une forme sensiblement plane et comporte une première face 4 destinée à être en contact avec la source chaude et une deuxième face 6 opposée à la première face 4. La deuxième face 6 du dispositif d'absorption thermique est apte à être disposée sur un autre élément (non représenté) tel qu'un support, par exemple de type PCB (pour « Printed circuit board »), ce support pouvant être lui-même rattaché à un dispositif dissipateur thermique encore appelé dispositif de refroidissement. Typiquement, le dispositif de refroidissement est un radiateur à ailettes ou une structure à canaux fluidiques. Un flux thermique F est ainsi destiné à se propager de la première face 4 vers la deuxième face 6.

Dans l'exemple des figures 1A-1B, les première et deuxième faces 4, 6 s'étendent dans une direction sensiblement parallèle à un plan [0; x; y] d'un repère orthogonal [0; x; y; z].

Le dispositif d'absorption de chaleur est formé d'un réseau de cellules 8 distinctes (encore appelés « ilots ») délimitées par des parois 10 latérales qui s'étendent entre la première face 4 et la deuxième face 6, dans cet exemple sensiblement orthogonale à la première face 4 et à la deuxième face 6. De manière avantageuse, les parois latérales 10 sont réalisées en nanotubes de carbone. Ceux-ci présentent un coefficient de conductivité thermique élevé, compris par exemple entre 6 $W.cm^{-1}.K^{-1}$ à 20 $W.cm-1.K^{-1}$. Les parois 10 sont formées de telle sorte que les nanotubes forment un matériau dense dans lequel les nanotubes sont en contact entre eux par le biais de leur surface latérale.

Les cellules 8 sont dotées chacune d'au moins une cavité encore appelée « canal ». Dans cet exemple, les cellules sont avantageusement dotées de plusieurs canaux 11 distincts qui s'étendent parallèlement aux parois latérales 10 entre la première face 4 et la deuxième face 6, c'est à dire sensiblement selon la direction du flux thermique. Les canaux 11 sont réalisés entre des cloisons 13 en nanotubes de carbone et forment des réservoirs pour au moins un premier matériau à changement de phase 12 (MCP). Dans le présent exemple, les canaux 11 sont prévus avec une forme cylindrique qui, comme on le verra par la suite peut permettre de favoriser leur remplissage par le premier matériau à changement de phase (MCP) 12.

La longueur des canaux 11 (mesurée parallèlement à l'axe z dans l'exemple donné sur les figures) est sensiblement égale ou proche de celle des nanotubes de carbone. Cette longueur peut être comprise par exemple entre 5 $\mu$m et 1000 $\mu$m. Les canaux 11 ont une dimension critique $\Delta_1$ (dimension mesurée parallèlement à la première face ou au plan [0; x; y]) qui peut être comprise par exemple entre 5 $\mu$m et 50 $\mu$m, de préférence de l'ordre de 10 $\mu$m. Les canaux 11 peuvent être séparés entre eux d'une distance d' proche de la dimension critique $\Delta_1$ des canaux, cette distance d' pouvant être comprise par exemple entre 5 $\mu$m et 50 $\mu$m.

Sur l'exemple des figures 1A et 1B, les cellules 8 ont une forme hexagonale, le réseau ayant une allure de nid d'abeille. Dans ce cas, on peut prévoir des cellules avec une section D (distance entre deux parois latérales opposées c'est-à-dire entre deux faces opposées de l'hexagone) comprise par exemple entre 50 $\mu$m et 1000 $\mu$m, ou par exemple de l'ordre de 410 $\mu$m ou de 610 $\mu$m.

Cette forme des cellules 8 n'est pas exclusive, et un réseau sous forme de cellules carrées ou rectangulaires, ou circulaires ne sort pas du cadre de la présente invention. La structure en nid d'abeille présente l'avantage d'offrir une bonne tenue mécanique. Dans l'exemple représenté, les cellules 8 ont toutes la même taille, cependant on pourrait prévoir des cellules de différentes tailles et/ou différentes formes au sein du même dispositif d'absorption thermique.

Le dispositif d'absorption thermique suivant l'invention comporte au moins un deuxième matériau à changement de phase 14, différent du premier matériau à changement de phase 12 et qui est agencé autour d'au moins une cellule 8 du réseau. Le dispositif comporte deux ensembles de structures 8, 9 dont l'une (les cellules 8) est fermée, l'autre (les passages 9) est ouverte et interconnectée, de façon à permettre une éventuelle circulation de matériau à changement de phase.

Les matériaux à changement de phase 12, 14 sont choisis de sorte qu'ils passent de l'état solide à l'état liquide lors d'une surcharge thermique de la source chaude.

Lorsque cette source chaude est un dispositif électronique, le premier matériau à changement de phase 12 et le deuxième matériau à changement de phase 14 sont choisis de préférence de sorte à avoir des température de fusion respectives situées dans une plage de fonctionnement normal de ce dispositif électronique destiné à être placé sur la première face 4.

Les matériaux 12, 14 MCP peuvent être choisis de sorte à avoir des températures de changement de phase solide/liquide (ou température de fusion) respectives $T_{F1}$, $T_{F2}$, comprises par exemple entre 30°C et 250°C.

De préférence, on prévoit le deuxième matériau 14 MCP disposé dans les passages 9, avec une température de fusion TF2 inférieure à celle TF1 du premier matériau 12 MCP.

Selon une configuration possible, on prévoit un premier matériau à changement de phase 12 de nature organique, par exemple de type $C_xH_y$, et qui présente une bonne affinité avec la structure d'accueil, ici en nanotubes de carbone. On entend en particulier une affinité dans un état liquide du matériau à changement de phase. Dans le cas notamment où cette structure d'accueil est en nanotubes de carbone, le premier matériau à changement de phase 12 peut être une paraffine ($C_nH_{2n+2}$), par exemple telle que de l'eicosane ($C_{20}H_{42}$).

Le deuxième matériau à changement de phase 14 peut être de nature organique ou inorganique et de préférence choisi de sorte à avoir une bonne conductivité thermique. Le deuxième matériau à changement de phase 14 peut être en particulier un matériau métallique tel que par exemple de l'InAg ou de l'InSnZn.

Une particularité du dispositif d'absorption thermique est que dans un même plan parallèle à la première face 4 ou à la deuxième face 6 (i.e. un plan parallèle au plan [0; x; y] sur les figures 1A, 1B), plusieurs matériaux 12, 14 à changement de phase ayant des températures de fusion différentes, sont aptes à pouvoir mettre en oeuvre un écrêtage ou une limitation d'échauffements respectifs différents subis par différentes zones au niveau de la première face 4.

Un tel type d'écrêtage s'avère utile en particulier lorsque le dispositif électronique agencé sur la première face 4 comporte plusieurs composants ayant des plages de fonctionnement différentes en puissance dissipées et/ou des températures critiques différentes de fonctionnement.

Le deuxième matériau à changement de phase 14 est ici disposé dans des passages 9 situés entre cellules 8 c'est-à-dire dans des espaces délimités entre des parois latérales 10 de différentes cellules 8. Les passages 9 sont séparés des canaux 11 par les cloisons en nanotubes de carbone, de préférence de sorte que les réservoirs respectivement à premier matériau de changement de phase et à deuxième matériau de changement de phase ne communiquent pas entre eux.

Les passages 9 ont une dimension critique $\Delta_2$ (dimension mesurée parallèlement à la première face ou au plan [0; x; y]) prévue supérieure à la dimension critique $\Delta_1$ des canaux 11. Comme on le verra par la suite, cela permet, lors de la fabrication du dispositif, de favoriser le remplissage des canaux 11 par le premier matériau 12 MCP.

Dans l'exemple de réalisation illustré sur la figure 1A, l'agencement des passages 9 par rapport aux cellules 8 est tel qu'une cellule 8 dotée de plusieurs canaux 11 renfermant le premier matériau à changement de phase 12 peut être entièrement entourée d'un passage 9 rempli du deuxième matériau à changement de phase 14. Les passages 9 entre cellules 8 du réseau peuvent être connectés entre eux.

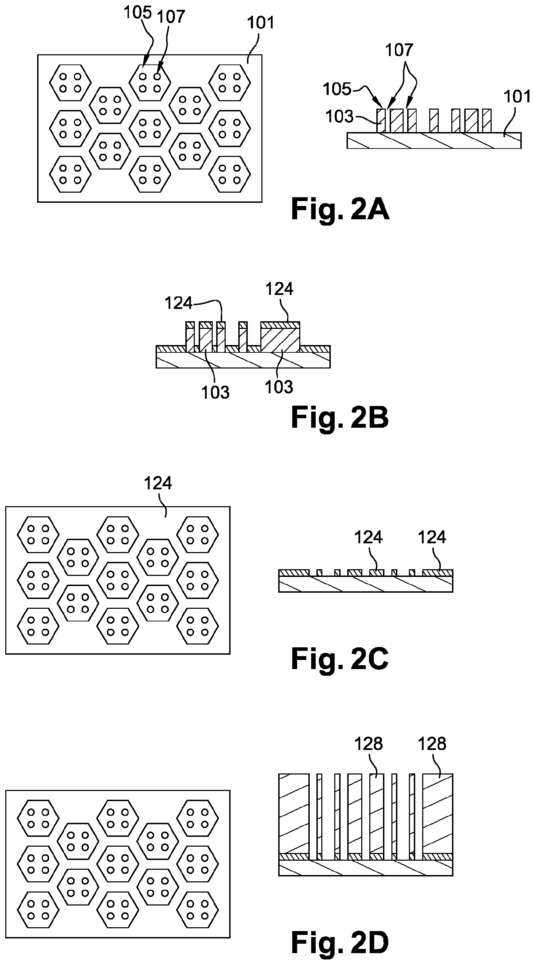

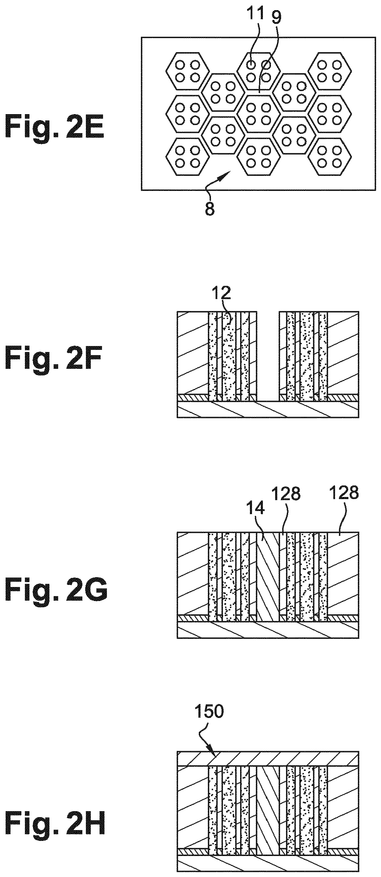

Nous allons maintenant décrire un exemple de procédé de fabrication d'un dispositif d'absorption thermique selon l'invention dont les étapes sont représentées schématiquement sur les figures 2A à 2H.

Lors d'une première étape, on réalise un réseau de cellules 105 dans une couche de masquage 103 déposée préalablement sur une face d'un support 101 et on effectue une lithographie du motif à réaliser, par exemple par photolithographie lorsque la couche de masquage 103 est en résine photosensible.

Dans le cas représenté sur la figure 2A, il s'agit d'un motif en nid d'abeille avec des cellules sous forme de blocs hexagonaux comportant des trous verticaux 105 traversant.

Lors d'une étape suivante (figure 2B), on effectue un dépôt d'un catalyseur 124 par exemple par dépôt physique en phase vapeur (PVD). Le catalyseur 124 est par exemple une couche de fer ou un système bicouches comportant une couche d'alumine et une couche de fer. Le catalyseur 124 est disposé autour des blocs de masquage, sur les blocs de masquage et au fond des trous verticaux traversant ces blocs.

Lors d'une étape suivante, on effectue un retrait du masquage 103, par exemple à l'aide d'un procédé de décapage (« stripping » selon la terminologie anglo-saxonne) lorsqu'il est à base de résine, les zones de catalyseur 124 disposées directement sur le support 101 étant conservées (figure 2C).

Lors d'une étape suivante, on fait croître des nanotubes 128 de carbone, en particulier par dépôt chimique en phase vapeur thermique avec un mélange $C_2H_2$, $H_2$, He avec des flux gazeux respectifs par exemple de 10, 50, 50 $cm^3$/min par exemple à une température comprise entre 550°C et 750°C, et une pression comprise par exemple entre 0,1 mbar et 10 mbar. La hauteur des nanotubes est fixée par le temps de croissance et peut être de l'ordre par exemple d'une ou plusieurs centaines de micromètres (figure 2D).

Lors d'une étape suivante avantageuse, on peut réaliser une compaction des tubes par immersion dans une solution d'alcool. Lors du séchage à l'air, les parois en nanotubes collapsent et forment un matériau dense dans lequel les nanotubes sont en contact (figure 2E).

On forme ainsi sur le support 101 un réseau de cellules 8 ou d'ilots en nanotubes de carbone comportant des canaux 11, les cellules 8 étant séparées entre elles par des espaces ou passages 9 délimités entre des parois latérales 10 de différentes cellules 8.

Lors d'étapes suivantes (figures 2F-2G) on effectue un remplissage des canaux 11 et des passages 9 par différents matériaux à changement de phase.

Un exemple de méthode de remplissage va à présent être donné.

Dans une première étape (figure 2F) effectuée à une température T1 telle que T1 > TF1, un premier matériau à changement de phase 12 de température de fusion TF1 est apporté sous forme liquide ou fondu sur la structure en nanotubes de carbone. De préférence, le premier matériau MCP 12 a une affinité importante avec cette structure d'accueil et présente en en particulier une mouillabilité importante sur les nanotubes ainsi qu'une faible viscosité.

Par mouillabilité « importante », on entend qu'une goutte du premier matériau MCP 12 dans un état liquide réparti sur une surface d'accueil en nanotubes de carbone est telle que l'angle entre la surface liquide et la surface solide en contact avec le liquide est inférieur à 60° et de préférence à 45°.

Le premier matériau à changement de phase 12 sous forme liquide entre par capillarité et se déplace préférentiellement dans les structures de plus petites dimension, en particulier dans les canaux 11 de dimension critique $\Delta_1$ où l'énergie de surface du liquide est minimisée.

En effet, la pression capillaire Pcap peut s'écrire sous la forme :

$$Pcap = \frac{2 \times \sigma \times \cos(\theta)}{0.5\Delta 1}$$

avec $\sigma$ ($J/m^2$) : la tension de surface du liquide, $\theta$ : l'angle de contact entre la structure d'accueil et le liquide et $0.5\Delta1$ le rayon des canaux 11 formant des capillaires.

Ainsi lorsque $\theta$ est inférieur à 90° la structure est dite mouillante et dans cette configuration la pression capillaire entraine préférentiellement le liquide au fond des canaux 11 de dimension critique $\Delta_1$ plutôt que dans les passages 9 de dimension critique $\Delta_2$. Pour permettre un écoulement dans les capillaires on choisit un liquide de faible viscosité, c'est-à-dire inférieure à 1000 cP et comprise avantageusement entre 1 et 10 cP.

La quantité du premier matériau à changement de phase 12 apportée pour effectuer le remplissage est calculée de manière à remplir de préférence seulement les volumes des canaux 11, tandis que les espaces ou passages 9 inter-cellules 8 plus larges, sont laissés vides après avoir servi de chemin de transport.

La maitrise de ce remplissage est liée à la quantité de matériau à changement de phase 12 qui est introduite, celle-ci étant prévue à l'aide d'une estimation du taux de vide de la structure d'accueil et en particulier du volume des canaux 11. Cette estimation peut être réalisée à l'aide d'une ou plusieurs images obtenues par exemple par microscope du réseau de cellules vides, puis d'un calcul de taille des canaux 11 à partir de cette ou ces images. Une analyse d'image permet de calculer une surface de vide puis on multiplie cette valeur par la hauteur de la structure afin d'estimer un volume. Une fois ce volume estimé, on en déduit la masse de matériau à changement de phase 12 à prévoir, ce matériau MCP 12 étant pesé puis fondu sur le réseau de cellules.

Après remplissage des canaux 11 par le premier matériau à changement de phase 12, on peut rétablir une température environnante au réseau de cellules 8 inférieure à TF1 de sorte que le premier matériau à changement de phase retrouve son état solide.

Puis, dans un deuxième temps, le deuxième matériau à changement de phase 14 de température de fusion TF2 inférieure à celle du premier matériau 12 est disposé sous forme liquide ou fondu sur la structure d'accueil.

Ce procédé est effectué à une température T comprise entre la température de fusion TF2 du deuxième matériau à changement de phase et celle TF1 du premier matériau à changement de phase, de sorte à rendre liquide ou garder le deuxième matériau à changement de phase 14 sous forme liquide, tout en gardant le premier matériau à changement de phase 12 dans sa forme solide. Ainsi, le deuxième matériau à changement de phase 14 s'introduit dans les espaces ou passages 9 entre cellules 8.

L'ensemble ainsi obtenu est un réseau composite formé d'une structure thermiquement conductrice, par exemple en nanotubes de carbone avec une ou plusieurs cellules 8 dotées de canaux 11 verticaux qui s'étendent dans la direction des nanotubes et sont remplis du premier matériau à changement de phase 12 de température de changement d'état solide-liquide TF1, et au moins un passage 9 entre cellules 8 rempli du deuxième matériau à changement de phase 14 de température de changement d'état solide-liquide TF2.

Le support 101 sur lequel sont bâtis les nanotubes peut servir à fermer une première extrémité des canaux 11 et passages 9 remplis de matériau à changement de phase, tandis qu'une deuxième extrémité peut être fermée à l'aide d'un capot 150 rapporté sur la structure (figure 2H). Le capot 150 peut être par exemple en cuivre.

Le dispositif d'absorption thermique peut être lui-même reporté ensuite sur un dispositif électronique.

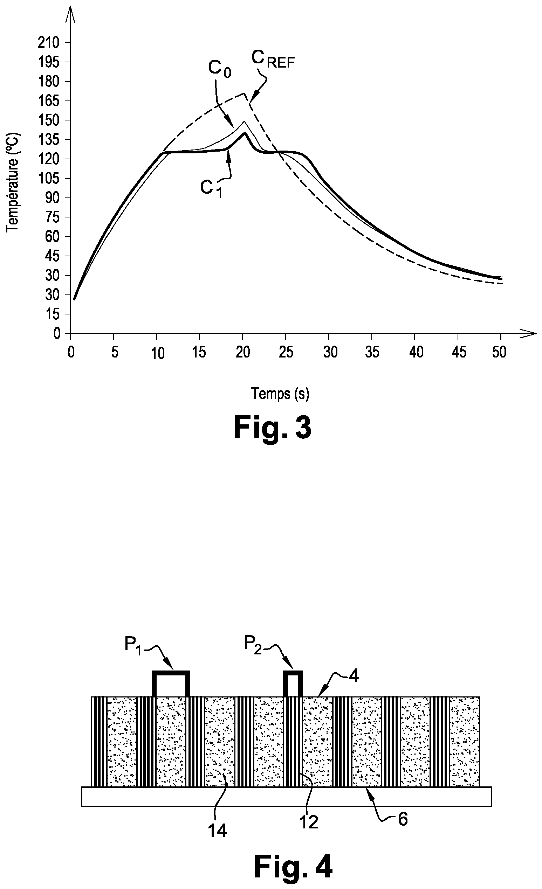

Sur la figure 3, une courbe $C_1$ temps-température sert à illustrer les performances d'un exemple particulier de réalisation du dispositif d'absorption thermique.

Dans cet exemple, le premier matériau à changement de phase 12 est de l'A144™ développé par PCMPRODUCTS tandis que le deuxième matériau à changement de phase 14 est en InAg. La structure d'accueil conductrice en nanotubes de carbones est ici refermée par deux plaques de cuivre disposées sur une face supérieur et une face inférieur du réseau. Ces plaques forment la première face et la deuxième face du dispositif d'absorption thermique. La source, chaude à laquelle le dispositif est ici est accolée, a une puissance dissipée uniforme sur la première face du dispositif d'absorption thermique qui est de l'ordre de 3W/cm$^2$. A titre de comparaison, des courbes $C_{ref}$ (en traits discontinu) et $C_0$ sont données. La courbe $C_{ref}$ a été obtenue à l'aide d'une structure constituée de plaques de cuivre disposées respectivement sur une face supérieure et une face inférieure d'une plaque de silicium. La courbe $C_0$ illustre quant à elle les performances d'un dispositif d'absorption formé d'une structure en nanotubes de carbone telle que décrite précédemment en liaison avec les figures 1A-1B, mais dans laquelle un seul matériau à changement de phase est intégré dans les canaux et les passages inter-cellules.

On constate ainsi qu'avec le dispositif d'absorption thermique suivant l'invention, la valeur de température maximale est abaissée par rapport au cas où seul un matériau à changement de phase est intégré.

Le deuxième matériau à changement de phase 14 métallique peut avoir une masse volumique d'environ 8000 kg/m$^3$ tandis que le premier matériau à changement de phase 12 de nature organique peut avoir une masse volumique avoisinant les 800 kg/m$^3$.

Or, si la chaleur latente du deuxième matériau 14 est de 34 J/g comparativement à un premier matériau 12 de 200 J/g alors pour un même volume disponible donné (par exemple 10 mm$^3$), l'énergie que peut stocker le premier matériau 12 est de 160 J tandis que l'énergie que peut stocker le deuxième matériau 14 est de 272 J.

Avec le dispositif intégrant plusieurs matériaux à changement de phase, on réalise par conséquent un meilleur écrêtage thermique.

Un dispositif d'absorption thermique suivant l'invention est particulièrement adapté à une source chaude non uniforme c'est à dire dont la puissance dissipée n'est pas la même sur toute la première face du dispositif.

Le dispositif de la figure 4 illustre un agencement avec une source chaude formée d'éléments ayant des dissipations thermique respectives différentes disposées sur une même face du dispositif d''absorption thermique.

La source chaude comprend un premier composant (ou une première puce) P1 disposé(e) sur la première face 4 du dispositif d'absorption thermique et en particulier sur un passage formant un réservoir au deuxième matériau à changement de phase 14. Un deuxième composant (ou une deuxième puce) P2 est également disposé(e) sur les canaux 11 formant un réservoir au premier matériau à changement de phase 12. Le premier composant P1 et le deuxième composant P2 ont des puissances dissipées différentes et/ou des températures critiques de fonctionnement différentes. Ainsi chaque puce ou composant électronique est reporté(e) au-dessus d'un réservoir de matériau à changement de phase dédié à son propre écrêtage thermique.

Le deuxième composant P2 qui génère le plus de chaleur est reporté au-dessus des cellules 8 formées de structures conductrices en nanotubes et de canaux verticaux remplis du premier matériau à changement de phase 12, tandis que le premier composant P1 qui génère moins de chaleur est reporté sur une surface située en regard des passages inter-cellules 8 (inter-ilots) remplis du deuxième matériau à changement de phase 14.

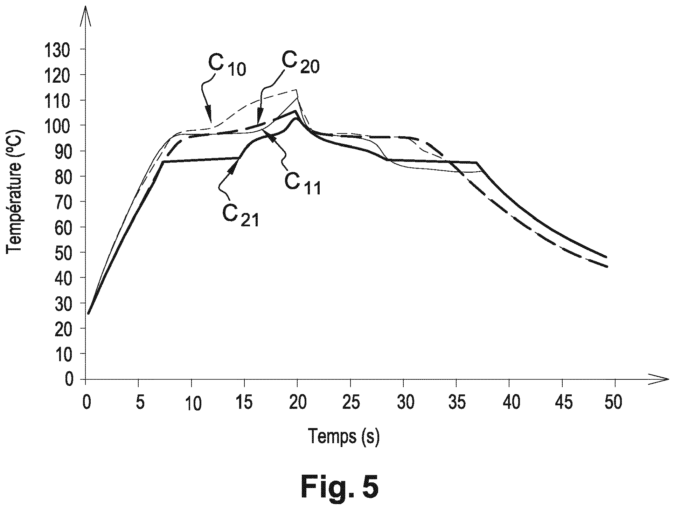

La figure 5 sert à illustrer les performances d'un tel système dans lequel le couple de matériaux MCP est prévu avec des température de fusion TF1, TF2 respectives du premier matériau à changement de phase et du deuxième matériau à changement de phase 12, 14 qui diffèrent l'une par rapport à l'autre d'au moins 10°C.

Les courbes $C_{11}$, $C_{21}$ temps-températures sont représentatives de mesures effectuées respectivement avec un système tel que décrit plus haut dans lequel le deuxième composant P2 génère un flux thermique de l'ordre de 4W/cm$^2$ tandis que le premier composant P1 génère un flux thermique de l'ordre de 1W/cm$^2$.

Les températures de fusion TF1 et TF2 du premier matériau à changement de phase 12 et du deuxième matériau à changement de phase 14 sont comprises respectivement entre 95-97°C et 85-87°C.

A titre de comparaison, les courbes $C_{10}$, $C_{20}$ sont représentatives de mesures effectuées respectivement sur un système semblable à celui de la figure 4 mais intégrant un seul matériau à changement de phase.

Dans l'exemple présenté, on essaie de se placer dans des conditions telles que le deuxième composant P2 (courbes $C_{10}$ et $C_{11}$) ne subisse pas une température de plus de 110°C durant plus de 5 secondes et que le premier composant P1 (courbes $C_{20}$ et $C_{21}$) ne subisse pas une température de plus de 95°C durant plus de 10 secondes.

Le système configuré avec deux matériaux à changement de phase (courbes $C_{11}$ et $C_{21}$) permet de remplir ces critères dépendant des spécifications des composants P1, P2. En revanche, la configuration avec un seul matériau à changement de phase (courbes $C_{10}$ et $C_{20}$) ne le permet pas puisque les températures restent trop élevées.

Dans l'un ou l'autre des exemples de réalisation qui viennent d'être décrits on intègre deux matériaux à changement de phase MCP différents dans deux enceintes distinctes situées dans un même plan parallèle à la première face du réseau de cellules.

Il est également possible d'intégrer un nombre de matériaux à changement de phase supérieur à deux en tenant compte par exemple du nombre de composants différents que l'on souhaite disposer sur une face du dispositif.

Les exemples de réalisation qui viennent d'être donnés concernent une structure d'accueil des matériaux à changement de phase qui est faite en nanotubes de carbone. Une structure de réseau semblable réalisée dans un autre matériau, par exemple en silicium, ne sort pas du cadre de la présente invention. Dans ce cas, les cellules peuvent être définies par un procédé de gravure de type DRIE pour (« Deep Reactive Ion Etching » ou « gravure ionique réactive profonde »).

Le dispositif d'absorption thermique à plusieurs matériaux à changement de phase selon l'invention permet de gérer thermiquement des sources de chaleur transitoires ou intermittentes, et s'adapte en particulier à des dispositifs électroniques 3D, c'est-à-dire dont les composants sont répartis sur 3 dimensions. De tels dispositifs sont par exemple dotés de plusieurs niveaux de transistors superposés.

**Revendications**

1. Dispositif d'absorption thermique comportant une première face (4) destinée à être en contact avec une source chaude et une deuxième face (6) opposée à la première face, un réseau de cellules (8) remplies d'un premier matériau à changement de phase (12) étant disposé entre la première face et la deuxième face, au moins une première cellule et au moins une deuxième cellule du réseau étant disposées dans un même plan parallèle à la première face, la première cellule comportant une première paroi latérale qui s'étend entre la première (4) face et la deuxième face (6) tandis que la deuxième cellule comporte au moins une première paroi latérale qui s'étend entre la première (4) face et la deuxième face (6), le réseau de cellules (8) étant agencé de sorte qu'un passage (9) est prévu entre la première paroi latérale et la deuxième paroi latérale et que ce passage (9) est rempli d'au moins un deuxième matériau à changement de phase (14) différent du premier matériau à changement de phase (12).

2. Dispositif selon la revendication 1, dans lequel la première paroi latérale et la deuxième paroi latérale sont formées en nanotubes de carbone.

3. Dispositif selon l'une des revendications 1 ou 2, dans lequel au moins la première cellule comporte plusieurs canaux (11) distincts qui s'étendent entre la première (4) face et la deuxième face (6) parallèlement à la première paroi latérale.

4. Dispositif selon l'une des revendications 1 à 3, dans lequel le premier matériau à changement de phase (12) a une première température de fusion (TF1) et dans lequel le deuxième matériau à changement de phase (14) a une deuxième température de fusion (TF2), la deuxième température de fusion étant inférieure à la première température de fusion (TF1).

5. Dispositif selon l'une des revendications 1 à 4, dans lequel le premier matériau à changement de phase est une paraffine.

6. Dispositif selon l'une des revendications 1 à 5, le deuxième matériau à changement de phase étant métallique.

7. Système électronique comportant :

   - au moins un premier composant électronique (P1) formant une première source de chaleur,
   - au moins un deuxième composant électronique (P2) formant une deuxième source de chaleur,
   - au moins un dispositif d'absorption thermique selon l'une des revendications 1 à 6, le premier composant électronique et le deuxième composant électronique étant en contact thermique avec la première face (4) du dispositif d'absorption thermique.

8. Procédé de fabrication d'un dispositif d'absorption thermique selon l'une des revendications 1 à 6, comportant les étapes de :

   a) remplissage d'au moins une première cellule et d'au moins une deuxième cellule du réseau avec un premier matériau à changement de phase dans son état liquide,
   b) remplissage d'un passage situé entre la première cellule et la deuxième cellule avec un deuxième matériau à changement de phase dans son état liquide.

9. Procédé selon la revendication 8, dans lequel la première cellule comporte plusieurs canaux (11) distincts, les canaux ayant une dimension critique ($\Delta_1$)

inférieure à une dimension critique ($\Delta_2$) du passage entre la première cellule et une deuxième cellule.

10. Procédé selon l'une des revendications 8 ou 9, dans lequel le premier matériau à changement de phase (12) a une première température de fusion (TF1) supérieure à la température de fusion (TF2) du deuxième matériau à changement de phase (14), le remplissage étant réalisé à une température inférieure à la température de fusion du premier matériau à changement de phase.

11. Procédé selon l'une des revendications 8 à 10, comprenant préalablement à l'étape a) des étapes de :

- définition d'un motif du réseau de cellules dans un masquage (103) formé sur un support (101), puis
- dépôt d'une couche de catalyseur (124), puis
- retrait du masquage, puis
- croissance de nanotubes de carbone de sorte à définir le réseau de cellules avec des parois latérales en nanotubes de carbone.

**Patentansprüche**

1. Wärmeabsorptionsvorrichtung, enthaltend eine erste Seite (4), die dazu bestimmt ist, mit einer heißen Quelle in Kontakt zu stehen, und eine zweite Seite (6), die der ersten Seite gegenüberliegt, wobei zwischen der ersten Seite und der zweiten Seite eine Netzanordnung aus Zellen (8) angeordnet ist, die mit einem ersten Phasenwechselmaterial (12) gefüllt sind, wobei zumindest eine erste Zelle und zumindest eine zweite Zelle der Netzanordnung in einer gleichen Ebene parallel zu der ersten Seite angeordnet sind, wobei die erste Zelle eine erste Seitenwand aufweist, die sich zwischen der ersten Seite (4) und der zweiten Seite (6) erstreckt, während die zweite Zelle zumindest eine erste Seitenwand aufweist, die sich zwischen der ersten Seite (4) und der zweiten Seite (6) erstreckt, wobei die Netzanordnung von Zellen (8) so angeordnet ist, dass ein Durchgang (9) zwischen der ersten Seitenwand und der zweiten Seitenwand vorgesehen ist und dass dieser Durchgang (9) mit zumindest einem zweiten Phasenwechselmaterial (14) gefüllt ist, das sich von dem ersten Phasenwechselmaterial (12) unterscheidet.

2. Vorrichtung nach Anspruch 1, wobei die erste Seitenwand und die zweite Seitenwand aus Kohlenstoffnanoröhrchen gebildet sind.

3. Vorrichtung nach einem der Ansprüche 1 oder 2, wobei zumindest die erste Zelle mehrere separate Kanäle (11) aufweist, die sich zwischen der ersten Seite (4) und der zweiten Seite (6) parallel zur ersten Seitenwand erstrecken.

4. Vorrichtung nach einem der Ansprüche 1 bis 3, wobei das erste Phasenwechselmaterial (12) eine erste Schmelztemperatur (TF1) hat und wobei das zweite Phasenwechselmaterial (14) eine zweite Schmelztemperatur (TF2) hat, wobei die zweite Schmelztemperatur geringer ist als die erste Schmelztemperatur (TF1).

5. Vorrichtung nach einem der Ansprüche 1 bis 4, wobei das erste Phasenwechselmaterial ein Paraffin ist.

6. Vorrichtung nach einem der Ansprüche 1 bis 5, wobei das zweite Phasenwechselmaterial metallisch ist.

7. Elektronisches System, enthaltend.

- zumindest eine erste elektronische Komponente (P1), die eine erste Wärmequelle bildet,
- zumindest eine zweite elektronische Komponente (P2), die eine zweite Wärmequelle bildet,
- zumindest eine Wärmeabsorptionsvorrichtung nach einem der Ansprüche 1 bis 6, wobei die erste elektronische Komponente und die zweite elektronische Komponente in Wärmekontakt mit der ersten Seite (4) der Wärmeabsorptionsvorrichtung sind.

8. Verfahren zum Herstellen einer Wärmeabsorptionsvorrichtung nach einem der Ansprüche 1 bis 6, umfassend die nachfolgenden Schritte:

a) Füllen zumindest einer ersten Zelle und zumindest einer zweiten Zelle der Netzanordnung mit einem ersten Phasenwechselmaterial in seinem flüssigen Zustand,
b) Füllen eines Durchgangs, der zwischen der ersten Zelle und der zweiten Zelle liegt, mit einem zweiten Phasenwechselmaterial in seinem flüssigen Zustand.

9. Verfahren nach Anspruch 8, wobei die erste Zelle mehrere separate Kanäle (11) enthält, wobei die Kanäle eine kritische Abmessung ($\Delta_1$) haben, die kleiner als eine kritische Abmessung ($\Delta_2$) des Durchgangs zwischen der ersten Zelle und der zweiten Zelle ist.

10. Verfahren nach einem der Ansprüche 8 oder 9, wobei das erste Phasenwechselmaterial (12) eine erste Schmelztemperatur (TF1) hat, die höher ist als die Schmelztemperatur (TF2) des zweiten Phasenwechselmaterials (14), wobei das Füllen bei einer Temperatur unter der Schmelztemperatur des ersten Phasenwechselmaterials erfolgt.

11. Verfahren nach einem der Ansprüche 8 bis 10, enthaltend vor dem Schritt a) die folgenden Schritte:

   - Definieren eines Musters der Netzanordnung aus Zellen in einer Maske (103), die an einem Träger (101) ausgebildet ist, dann
   - Abscheiden einer Katalysatorschicht (124), dann
   - Entfernen der Maske, dann
   - Wachsen lassen von Kohlenstoffnanoröhrchen, so dass die Netzanordnung von Zellen mit Seitenwänden aus Kohlenstoffnanoröhrchen definiert wird.

**Claims**

1. Heat absorption device comprising a first face (4) intended to be in contact with a hot source and a second face (6) opposite to the first face, a network of cells (8) filled with a first phase change material (12) being arranged between the first face and the second face, at least one first cell and at least one second cell of the network being arranged in a same plane parallel to the first face, the first cell comprising a first lateral wall which extends between the first face (4) and the second face (6) whereas the second cell comprises at least one first lateral wall which extends between the first face (4) and the second face (6),
the network of cells (8) being laid out such that a passage (9) is provided between the first lateral wall and the second lateral wall and that this passage (9) is filled with at least one second phase change material (14) different from the first phase change material (12).

2. The heat absorption device according to any of the claims 1 or 2, wherein the first lateral wall and the second lateral wall are formed of carbon nanotubes.

3. The heat absorption device according to claim 1, wherein at least the first cell comprises several separate channels (11) which extend between the first face (4) and the second face (6) parallel to the first lateral wall.

4. The heat absorption device according to any of the claims 1 to 3, wherein the first phase change material (12) has a first melting temperature (TF1) and in which the second phase change material (14) has a second melting temperature (TF2), the second melting temperature being less than the first melting temperature (TF1).

5. The heat absorption device according to any of the claims 1 to 4, wherein the first phase change material is a paraffin.

6. The heat absorption device according to any of the claims 1 to 5, the second phase change material being metal.

7. An electronic system comprising:

   - at least one first electronic component (P1) forming a first heat source,
   - at least one second electronic component (P2) forming a second heat source,
   - at least one heat absorption device according to any of the claims 1 to 6, the first electronic component and the second electronic component being in thermal contact with the first face (4) of the heat absorption device.

8. A method of manufacturing a heat absorption device according to any of the claims 1 to 6, including:

   - filling at least one first cell and at least one second cell of the network with a first phase change material in the liquid state thereof,
   - filling a passage situated between the first cell and the second cell with a second phase change material in the liquid state thereof.

9. The method according to claim 8, in which the first cell comprises several separate channels (11), the channels having a critical dimension ($\Delta 1$) less than a critical dimension ($\Delta 2$) of the passage between the first cell and a second cell.

10. The method according to any of the claims 8 or 9, wherein the first phase change material (12) has a first melting temperature (TF1) greater than the melting temperature (TF2) of the second phase change material, the filling being carried out at a temperature less than the melting temperature of the first phase change material.

11. The method according to any of the claims 8 to 10, including prior to the filling of at least the first cell and to the filling of said passage, the steps of:

   - definition of a pattern of the network of cells in a masking (103) formed on a support (101), then
   - deposition of a layer of catalyst (124), then
   - removal of the masking, then
   - growth of carbon nanotubes so as to define the network of cells with lateral walls made of carbon nanotubes.

**Fig. 1A**

**Fig. 1B**

**Fig. 2A**

**Fig. 2B**

**Fig. 2C**

**Fig. 2D**

Fig. 2E

Fig. 2F

Fig. 2G

Fig. 2H

Fig. 3

Fig. 4

**Fig. 5**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

• WO 2013104620 A

**Littérature non-brevet citée dans la description**

• A carbon nanotube-based composite for the thermal control of heat loads. **SHAIKH et al.** Carbon. Elsevier, 2012, vol. 50, 542-550